# EUROPÄISCHE PATENTSCHRIFT

(11) **EP 0 347 778 B1**
(45) Veröffentlichungstag und Bekanntmachung des Hinweises auf die Patenterteilung: **31.05.1995**
(21) Anmeldenummer: 89111018.1
(22) Anmeldetag: 16.06.1989
(51) Int. Cl.: H01L 29/87

(54) **Diode mit verbessertem Abschaltverhalten**
Diode with a modified turn-off capability
Diode avec un comportement modifié pendant la coupure

(30) Priorität: 21.06.1988 DE 3820917
(43) Veröffentlichungstag der Anmeldung: 27.12.1989
(73) Patentinhaber: SIEMENS AKTIENGESELLSCHAFT, 80333 München (DE)
(72) Erfinder: Mourick, Paul-Christiaan, Dipl.-Ing., D-8521-Langensendelbach (DE)

(56) Entgegenhaltungen:
- EP-A- 0 021 899
- GB-A- 2 113 907

## Beschreibung

Die Erfindung bezieht sich auf eine Diode nach dem Oberbegriff des Patentanspruchs.

Eine solche auch als PSN-Struktur bezeichnete Diode ist beispielsweise aus dem Buch "Halbleiter" von A. Porst, erschienen 1973 im Verlag der Siemens AG, Berlin und München, S. 121 bis 124, bekannt. Nachteilig ist jedoch, daß es beim Abschalten einer solchen Diode, das heißt beim Übergang derselben aus dem Durchlaßzustand, in dem sie von einem bestimmten Laststrom durchflossen wird, in den sperrenden Zustand, zum Aufbau einer sehr hohen Sperrspannung an der Diode kommen kann, die unter Umständen zu ihrer Zerstorung führt.

Der beim Übergang in den sperrenden Zustand durch die Diode fließende, von einem äußeren Stromkreis aufgebrachte Rückstrom, der beim Anlegen einer Sperrspannung zwischen der kathodenseitigen und der anodenseitigen Elektrode in Kathoden-Anodenrichtung durch die Diode fließt, so lange im Mittelgebiet noch auszuräumende Ladungsträger vorhanden sind, kann in dem Moment, in dem außerhalb der sich am pn-Übergang zwischen dem Anodengebiet und dem Mittelgebiet aufbauenden Raumladungszone keine auszuräumenden Ladungsträger mehr existieren, ganz plötzlich abreißen. Dadurch entsteht dann ein sehr steiler Anstieg der Sperrspannung an der Diode, der die oben erwähnte Zerstörung bewirken kann.

Aus der europäischen Anmeldeschrift mit der Veröffentlichungsnummer EP 0 021 899 A1 ist eine Shockley-Diode bekannt, bei der zwischen einem hochdotierten, n-leitenden Kathodengebiet und einem hochdotierten, p-leitenden Anodengebiet nicht nur ein schwach dotiertes n-leitendes Mittelgebiet, sondern zwischen dem Mittelgebiet und dem Kathodengebiet eine p-leitende Basiszone eingefügt ist und das Mittelgebiet sowohl am kathodenseitigen Ende als auch am anodenseitigen Ende jeweils eine höher als das übrige Mittelgebiet dotierte n-leitende Zone aufweist.

Der Erfindung liegt die Aufgabe zugrunde, eine Diode der eingangs genannten Art anzugeben, die ohne Abreißen des Rückstroms aus dem Durchlaßzustand in den sperrenden Zustand umgeschaltet, das heißt abkommutiert werden kann. Das wird erfindungsgemäß durch eine Ausbildung nach dem kennzeichnenden Teil des Patentanspruchs erreicht.

Der mit der Erfindung erzielbare Vorteil besteht insbesondere darin, daß beim Abschalten der Diode genügend Ladungsträger zur Verfügung stehen, um den zum Abkommutieren notwendigen Rückstrom bis zum vollständigen Aufbau der Sperrspannung an der Diode aufrecht zu erhalten.

Der Erfindung wird nachfolgend anhand eines in der Zeichnung dargestellten, bevorzugten Ausführungsbeispiels näher erläutert. Dabei zeigt:
- Figur 1: den prinzipiellen Aufbau einer nach der Erfindung ausgebildeten Diode,
- Figur 2: das Dotierungsprofil der Diode nach Figur 1,
- Figur 3: ein Diagramm zur Erläuterung des Abschaltvorgangs bei einer herkömmlichen Diode,
- Figur 4: die Ausräumung der Ladungsträger beim Abschalten einer erfindungsgemäßen Diode,
- Figur 5: den Abschaltvorgang bei einer erfindungsgemäßen Diode, und
- Figur 6: den über dem Durchlaßstrom aufgetragenen Verlauf der Durchlaßspannung bei einer Diode nach der Erfindung.

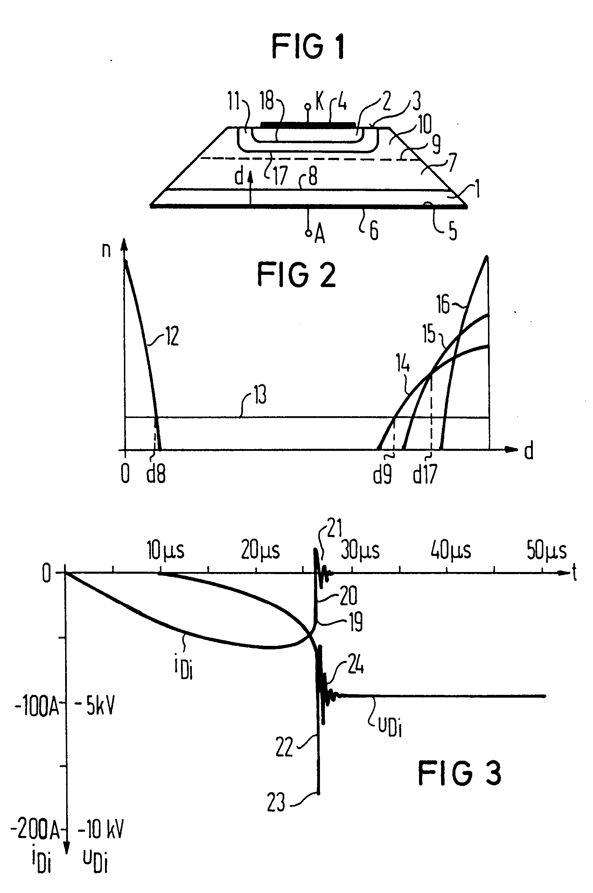

Die in Figur 1 dargestellte Halbleiterdiode besteht aus einem scheibenförmigen, dotierten Halbleiterkörper, zum Beispiel aus Silizium, der ein außenliegendes p-leitendes Anodengebiet 1 und ein außenliegendes, n-leitendes Kathodengebiet 2 aufweist. Das Kathodengebiet 2 wird in einer ersten Hauptfläche 3 von einer kathodenseitigen Elektrode 4 kontaktiert, die mit einem Anschluß K versehen ist. Das Anodengebiet 1 wird in einer zweiten Hauptfläche 5 von einer anodenseitigen Elektrode 6 kontaktiert, die einen Anschluß A aufweist. Mit 7 ist ein n-leitendes Mittelgebiet bezeichnet, das durch einen pn-Übergang 8 vom Anodengebiet 1 getrennt ist. Der Teil des Mittelgebiets 7, der oberhalb einer in Figur 1 durch die gestrichelte Linie 9 angedeuteten Querschnittsebene liegt, ist als eine n-leitende Stop-Zone 10 ausgebildet, die stärker dotiert ist als der übrige Teil des Mittelgebiets 7. Dabei verläuft die Querschnittsebene 9, die auch als Grenzfläche zwischen der Stop-Zone 10 und dem übrigen Teil des Mittelgebiets aufgefaßt werden kann, im wesentlichen parallel zum pn-Übergang 8. In die Stop-Zone 10 ist eine p-leitende Basiszone 11 so eingefügt, daß sie sich bis zur ersten Hauptfläche3 erstreckt und in lateraler Richtung von der Stop-Zone 10 allseitig umschlossen ist. Das Kathodengebiet 2 ist seinerseits so in die Basiszone 11 eingefügt, daß es sich bis zur Hauptfläche 3 erstreckt und in lateraler Richtung von der Basiszone 11 allseitig umgeben ist.

Fig. 2 zeigt das Dotierungsprofil der Diode nach Fig. 1 in einem Diagramm, auf dessen horizontaler Achse die Entfernungen d aller Orte, die auf einer senkrecht zur Hauptfläche 5 orientierten Geraden liegen, von dieser Hauptfläche 5 aufgetragen sind, während in vertikaler Richtung die zu diesen Orten gehörenden Dotierungskonzentrationen n aufgetragen sind. Mit 12 ist das Teilprofil des durch eine randseitige p-Diffusion hergestellten Anodengebiets 1 angedeutet, dessen Dotierungskonzentration in der Nähe der Hauptfläche 5 etwa 10¹⁹cm⁻³ beträgt. Die Grunddotierung des Halbleiterkörpers, die dem Mittelgebiet 7 entspricht und etwa 10¹³ bis 10¹⁴cm⁻³ beträgt, ist durch eine Gerade 13 angedeutet, während die Stop-Zone 10, die in der Nähe der Grenzfläche 3 eine Dotierungskonzentration von etwa 10¹⁵ bis 10¹⁶cm⁻³ aufweist, durch das Teilprofil 14, die p-leitende Basiszone 11 durch das Teilprofil 15 und das Kathodengebiet 2 durch das Teilprofil 16 gekennzeichnet sind. Die Dotierungskonzentration von 2 beträgt in der Nähe der Hauptfläche 3 etwa 10²⁰cm⁻³, die der Basiszone 11 etwa 4.10¹⁶ bis 10¹⁸cm⁻³. Der pn-Übergang 8 und der pn-ÜBergang 17 zwischen der p-leitenden Basiszone 11 und der Stop-Zone 10 sind in Fig. 2 ebenso wie die Grenzfläche 9 durch ihre Abstände d8, d9 und d17 gekennzeichnet.

Fig. 3 zeigt die Zeitabhängigkeit des Rückstroms i_{Di} und der Sperrspannung u_{Di} beim Abschalten einer lediglich aus den Teilen 1, 7 und 2 bestehenden, herkömmlichen PSN-Diode. Dabei entsprechen die Abschnitte auf der Zeitachse t jeweils 5 »s, die Abschnitte auf der vertikalen Achse jeweils 50 A bzw. 2,5 kV. Vorausgesetzt ist, daß über einen äußeren Stromkreis zwischen K und A eine die kathodenseitige Elektrode 4 gegenüber der anodenseitigen Elektrode 6 positiv vorspannende Sperrspannung angelegt wird und sich die Diode zum Zeitpunkt t = 0 im Durchlaßzustand befindet, so daß das Mittelgebiet 7 zu diesem Zeitpunkt mit Ladungsträgern beider Polaritäten überschwemmt ist. Beim Anlegen der Sperrspannung baut sich an dem in Sperrrichtung vorgespannten pn-Übergang 8 eine allmählich immer weiter nach oben in das Mittelgebiet 7 vordringende Raumladungszone auf, wobei die dort vorhandenen Elektronen und Löcher jeweils durch den einsetzenden Rückstrom i_{Di} in Richtung auf die kathodenseitige bzw. anodenseitige Elektrode 4 bzw. 6 abtransportiert werden (untere Ausräumzone). Gleichzeitig erfolgt aber auch ein Abbau der sich in der Nähe der Begrenzung 18 des Kathodengebiets 2 im Mittelgebiet 7 befindenden Ladungsträger, und zwar fortschreitend in Richtung nach unten, d.h. von 18 ausgehend immer weiter in das Mittelgebiet 7 hinein (obere Ausräumzone). Die wachsende Ausdehnung dieser beiden Ausräumzonen führt dazu, daß zunächst nur in einer zwischen diesen beiden Zonen befindlichen mittleren Zone ein Rest von auszuräumenden Ladungsträgern verbleibt. Beim weiteren Vordringen der Raumladungszone nach oben kann es sich nun ergeben, daß sie die obere Ausräumzone erreicht, bevor sich die volle Sperrspannung zwischen K und A aufgebaut hat. Nimmt man an, daß dies zu einem Zeitpunkt auftritt, zu dem der Rückstrom i_{Di} eine durch den Kurvenpunkt 19 gegebene Größe aufweist, so reißt i_{Di} ganz plötzlich ab, was durch den vertikalen Kurvenast 20 verdeutlicht wird. Nach einer Phase des Überschwingens 21 ist dann der Rückstrom auf einen in Fig. 3 nicht mehr erkennbaren Sperrstrom abgesunken. Der plötzliche Stromabriß bei 20 veranlaßt jedoch einen starken Anstieg 22 der Sperrspannung, der zu einem Spitzenwert 23 führt, welcher die Zerstörung der Diode oder der mit ihr verbundenen Schaltungsteile bewirkt. Der Überschwingphase 21 des Rückstroms i_{Di} entspricht eine Überschwingphase 24 der Diodenspannung u_{Di}, bevor u_{Di} den Wert der im äußeren Stromkreis vorhandenen Sperrspannung erreicht.

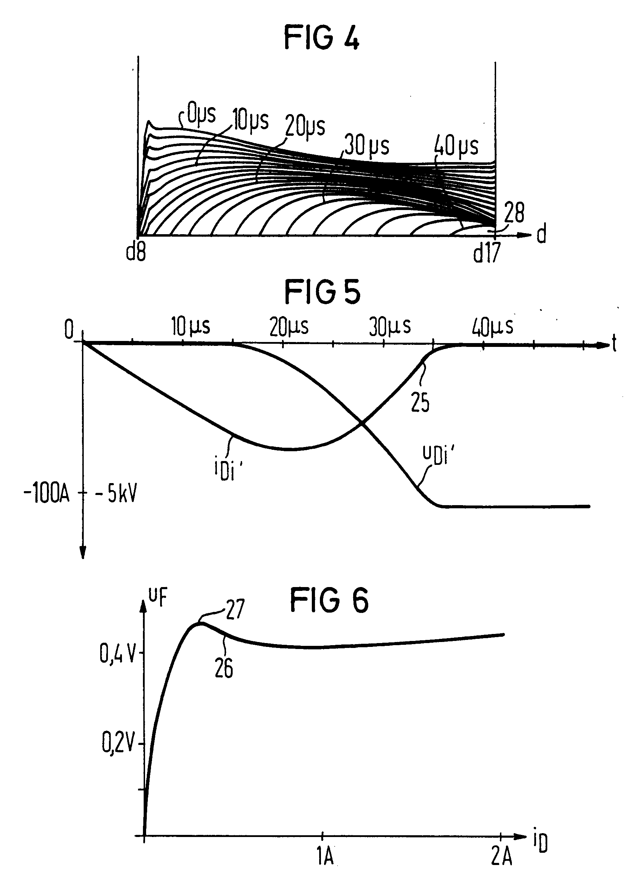

Der Ausräumvorgang bei einer erfindungsgemäßen, mit der Stop-Zone 10 und der p-leitenden Basiszone 11 versehenen Diode sei anhand von Fig. 4 näher beschrieben. Fig. 4 zeigt dabei eine Kurvenschar, die den Ladungsträgerabbau im Mittelgebiet 7 zwischen den horizontalen Querschnittsebenen mit den Entfernungen d8 und d17 (vgl. Fig. 2) von der Hauptfläche 5 veranschaulicht. Die Parameter der einzelnen Kurven entsprechen den nach dem Anlegen der Sperrspannung vergangenen Mikrosekunden. Die Fläche unter einer bestimmten Kurve stellt jeweils die Menge der im Mittelgebiet 7 zu dem Zeitpunkt, der durch den Parameter angegeben ist, noch verbliebenen Ladungsträger dar, wobei die Lage dieser Kurve auch die Zone kennzeichnet, in der diese Ladungsträger sich jeweils befinden. Wie hieraus ersichtlich, werden die Ladungsträger von d8 beginnend immer weiter in Richtung auf d17 abgebaut, wobei sich die zuerst in der Entfernung d8 von der Hauptfläche 5 aufbauende, untere Ausräumzone in Richtung nach oben immer weiter in das Mittelgebiet 7 hinein erstreckt. Da aus der p-leitenden Basiszone 2 immer wieder Ladungsträger in das Mittelgebiet 7 nachgeliefert werden, kann sich im Gegensatz zum Ausräumvorgang bei einer herkömmlichen PSN-Diode keine obere Ausräumzone ausbilden. Daher bleibt auch nach etwa 40 »s ein Ladungsträgerrest in einer Zone 28 bestehen, die an die durch d17 gekennzeichnete Querschnittsebene direkt anschließt. Das bedeutet aber, daß sich die am pn-Übergang 8 aufbauende Raumladungszone und damit die untere Ausräumzone so weit ausdehnen kann, wie es erforderlich ist, um die gewünschte Sperrspannung zwischen A und K zu erreichen, ohne daß es vorher zu einem Abreißen des Diodenstromes i_{Di} und damit zu einem Aufbau einer extrem großen Sperrspannung 23 kommen könnte.

Fig. 5 zeigt in Abweichung von Fig. 3 den Verlauf des Rückstroms i_{Di}′ und der Diodenspannung u_{Di}′ einer erfindungsgemäßen Diode, wobei eine durch den Kurvenast 25 gegebene all mähliche Abnahme von i_{Di}′ und ein dementsprechend allmählicher Aufbau von u_{Di}′ auf den Wert der im äußeren Stromkreis vorhandenen Sperrspannung festzustellen ist.

In Fig. 6 ist die Durchlaßspannung u_{F} einer Diode nach der Erfindung in Volt in Abhängigkeit vom Durchlaßstrom i_{D} in Ampere dargestellt. Man kann hieraus entnehmen, daß der pn-Übergang 17 zunächst bei kleinen Strömen sperrt. Erst nach Überschwemmung des Mittelgebiets 7 mit Ladungsträgern sinkt die Durchlaßspannung im Kurventeil 26 ab und entspricht im weiteren Verlauf dem einer herkömmlichen PSN-Diode. Um das mit 27 angedeutete lokale Spannungsmaximum klein zu halten, wird einerseits die Stop-Zone 10 so dotiert, daß sie eine von der p-leitenden Basiszone 2 nur wenig abweichende Dotierungskonzentration n aufweist. Das hat zur Folge, daß die sich am pn-Übergang 17 im Durchlaßzustand aufbauende Raumladungszone nur eine geringe Ausdehnung hat und daher nur eine geringe Spannung in Vorwärtsrichtung aufnehmen kann. Andererseits wird die Verstärkung des aus den Halbleiterzonen 10 und 11 sowie aus dem Kathodengebiet 2 bestehenden npn-Transistors groß gewählt. Beide Maßnahmen zusammengenommen bewirken, daß die erwähnte Überschwemmung des Mittelgebiets 7 schon bei niedrigen Werten des Durchlaßstroms i_{D} auftritt. Die Stop-Zone 10 hat weiterhin den Zweck, zu verhindern, daß die sich im sperrenden Zustand am pn-Übergang 8 aufbauende Raumladungszone noch vor dem Erreichen der Sperrspannung zwischen A und K soweit in Richtung auf die p-leitende Basiszone 11 ausgedehnt hat, daß sie diese erreicht, was einen "Punch Through" bedeuten würde.

## Patentansprüche

1. Diode mit einem Halbleiterkörper, der ein von einer kathodenseitigen Elektrode (4) kontaktiertes n-leitendes Kathodengebiet (2), ein von einer anodenseitigen Elektrode (6) kontaktiertes p-leitendes Anodengebiet (1) und ein schwächer als diese beiden Gebiete dotiertes, n-leitendes, von dem Anodengebiet (1) durch einen pn-Übergang (8) getrenntes Mittelgebiet (7) aufweist, wobei eine karhodenseitige Zone des Mittelgebietes eine n-leitende Stop-Zone (10) bildet, die stärker dotiert ist als das übrige Mittelgebiet (7),
**dadurch gekennzeichnet**,
daß in die Stop-Zone (10) eine p-leitende Basiszone (11) eingefügt ist, die sich bis zu einer kathodenseitigen Hauptfläche (3) erstreckt und in lateraler Richtung von der Stop-Zone (10) allseitig eingeschlossen ist, und daß das Kathodengebiet (2) derart in die Basiszone (11) eingefügt ist, daß es sich bis zur kathodenseitigen Hauptfläche (3) erstreckt und in lateraler Richtung allseitig von der Basiszone (11) umgeben ist und daß die Dotierung der p-leitenden Basiszone (11) geringfügig stärker ist als die Dotierung der Stop-Zone (10), aber wesentlich schwächer ist als die Dotierung des Kathoden- oder Anodengebiets (2 bzw. 1).

## Claims

1. Diode with a semiconductor body, having an n-conductive cathode region (2), with which a cathode-side electrode (4) makes contact, a p-conductive anode region (1), with which an anode-side electrode (6) makes contact, and an n-conductive centre region (7), which is doped more weakly than the latter two regions and is separated from the anode region (1) by a pn junction (8), a cathode-side region of the centre region forming an n-conductive barrier region (10), which is doped more strongly than the rest of the centre region (7), characterized in that a p-conductive base region (11) is inserted into the barrier region (10), which base region extends as far as a cathode-side main area (3) and is enclosed on all sides in the lateral direction by the barrier region (10), and in that the cathode region (2) is inserted into the base region (11) in such a way that it extends as far as the cathode-side main area (3) and is surrounded by the base region (11) on all sides in the lateral direction, and in that the doping of the p-conductive base region (11) is slightly stronger than the doping of the barrier region (10), but is substantially weaker than the doping of the cathode or anode region (2 or 1, respectively).

## Revendications

1. Diode comportant un corps semiconducteur qui comporte une région de cathode (2) conductrice du type n, placée en contact avec une électrode (4) située côté cathode, une région d'anode (1) conductrice de type p, placée en contact avec une électrode (6) située côté anode, et une région médiane (7) conductrice du type n, qui est plus faiblement dopée que lesdites deux régions et est séparée de la région d'anode (1) par une jonction pn (8), une zone, située côté cathode, de la région médiane constituant une zone d'arrêt (10) conductrice du type n, qui est plus fortement dopée que le reste de la région médiane (7),
caractérisée par le fait
que dans la zone d'arrêt (10) est insérée une zone de base (11) conductrice du type p, qui s'étend jusqu'à une surface principale (3) située côté cathode et est enserrée de tous côtés, dans une direction latérale, par la zone d'arrêt (10), et que la région de cathode (2) est insérée dans la zone de base (11) de telle sorte qu'elle s'étend jusqu'à la surface principale (3) située du côté cathode et est entourée de tous côtés, dans une direction latérale, par la zone de base (11), et que le dopage de la zone de base (11) conductrice de type p est légèrement supérieur au dopage de la zone d'arrêt (10), mais est nettement inférieur au dopage de la région de cathode ou d'anode (2 ou 1).
